Europäisches Patentamt

European Patent Office

Office européen des brevets

(19)

(11) Numéro de publication : **0 323 314 B1**

(12) **FASCICULE DE BREVET EUROPEEN**

(45) Date de publication du fascicule du brevet :
**12.08.92 Bulletin 92/33**

(51) Int. Cl.⁵ : **H03L 5/00, H03B 15/00**

(21) Numéro de dépôt : **88403251.7**

(22) Date de dépôt : **20.12.88**

(54) **Oscillateur à faible bruit.**

(30) Priorité : **30.12.87 FR 8718370**

(43) Date de publication de la demande :
**05.07.89 Bulletin 89/27**

(45) Mention de la délivrance du brevet :
**12.08.92 Bulletin 92/33**

(84) Etats contractants désignés :
**DE GB IT**

(56) Documents cités :
**FR-A- 1 417 634**
**US-A- 2 725 474**
**JOURNAL OF APPLIED PHYSICS, vol. 45, no.
11, novembre 1974, pages 5043-5049, American Institute of Physics, New York, US;J.W.
BAKER et al.: "Effects of a nonuniform current
distribution on the kinetic inductance of a thin
superconducting film"**

(73) Titulaire : **THOMSON-CSF
51, Esplanade du Général de Gaulle
F-92800 Puteaux (FR)**

(72) Inventeur : **Dusclaux, Didier
THOMSON-CSF SCPI 19, avenue de Messine
F-75008 Paris (FR)**
Inventeur : **Mage, Jean-Claude
THOMSON-CSF SCPI 19, avenue de Messine
F-75008 Paris (FR)**

(74) Mandataire : **Sciaux, Edmond et al
THOMSON-CSF SCPI
F-92045 PARIS LA DEFENSE CEDEX 67 (FR)**

## Description

L'invention concerne un oscillateur à faible bruit, notamment à faible bruit de phase aux environs de la fréquence centrale.

Un oscillateur classique comporte de la façon décrite par exemple dans le brevet FR 1 417 634, un résonateur constitué, par exemple, d'une inductance et d'une capacité ; un amplificateur ; et un élément non linéaire. L'amplificateur excite le résonateur en lui fournissant de l'énergie. Une partie de l'énergie emmagasinée dans le résonateur est prélevée pour être appliquée à l'entrée de l'amplificateur. La puissance fournie par la sortie de l'amplificateur est supérieure à la somme de la puissance dissipée par effet Joule dans le résonateur et de la puissance appliquée à l'entrée de l'amplificateur. L'amplitude de la tension de sortie de l'amplificateur augmenterait donc indéfiniment s'il n'y avait dans cette boucle un élément non linéaire réduisant le gain de la boucle quand l'amplitude de cette tension augmente. L'élément non linéaire de l'oscillateur est donc indispensable pour qu'il y ait une oscillation stable. L'élément non linéaire est souvent constitué par l'amplificateur lui-même car il devient non linéaire lorsqu'il sature.

La modélisation d'un tel oscillateur est décrite par : LEESON "Simple Model of a Feedback Oscillator Noise Spectrum" PROC. IEEE Vol. 54, Feb 1966 ; H.J. SIWERIS, B.CHIEK "Analysis of Noise Up Conversion in Microwave FET Oscillators" IEEE Tran MTT, vol MTT-33 p233-242, Mar 1985.

Cette modélisation permet de montrer que le bruit, au voisinage de la fréquence centrale, dans ce type d'oscillateur, est dû essentiellement à une conversion du bruit à basse fréquence de l'amplificateur en un bruit à haute fréquence, par un effet de repliement dû à la non linéarité de fonctionnement de l'amplificateur. L'amplificateur étant en général un dispositif à semi-conducteur ayant un bruit relativement important dans les basses fréquences, ce type d'oscillateur a un bruit de phase relativement élevé.

Il est connu de réduire le bruit d'un oscillateur en utilisant un résonateur ayant un coefficient de qualité très élevé. Mais cette solution est souvent complexe et coûteuse. D'autre part, elle n'est pas réalisable pour un oscillateur à fréquence commandée par une tension, car un tel oscillateur comporte une diode à capacité variable qui amortit le résonateur.

Il est connu, par :
M. MAMODALY, M. PRIGENT, J. OBREGON "New Configurations to Reduce Converted FM Noise in FET Oscillators" ; de séparer l'élément non linéaire et l'amplificateur, pour réduire le bruit de ce type doscillateur. Un dispositif connu comporte, comme élément non linéaire, deux diodes reliées tête-bêche en parallèle sur le résonateur pour écrêter la tension aux bornes du résonateur.

Un autre dispositif connu comporte un amplificateur linéaire et un dispositif de contrôle automatique du gain de cet amplificateur, permettant de régler automatiquement le gain de façon à compenser exactement les pertes dans les autres éléments de l'oscillateur, notamment le résonateur, en maintenant l'amplificateur dans une zone de fonctionnement linéaire. Ces deux dispositifs connus permettent de réaliser un oscillateur ayant moins de bruit que l'oscillateur classique utilisant l'amplificateur comme limiteur d'amplitude. Cependant cette réduction de bruit est encore insuffisante pour certains applications, et inapplicable dans certains cas.

Le but de l'invention est donc de proposer un oscillateur ayant un bruit plus réduit que celui de ces dispositifs connus, à qualité égale du résonateur. L'objet de l'invention est un oscillateur comportant un élément non linéaire utilisant les propriétés de transition qui sont propres aux matériaux supra-conducteurs. En effet la transition de l'état supraconducteur à l'état résistif, sous l'action dune élévation de température, ou sous l'action d'un champ magnétique, ou sous l'action d'un courant électrique, permet de réaliser l'élément non linéaire nécessaire pour stabiliser l'amplitude d'un oscillateur. Le matériau supra-conducteur étant utilisé à basse température, il introduit peu de bruit dans l'oscillation, puisque le bruit décroît très rapidement en fonction de la température.

Selon l'invention, un oscillateur à faible bruit comportant un résonateur connectés en boucle fermée à un amplificateur linéaire au moyen d'un élément inductif pour injecter une fraction de la puissance de sortie de l'amplificateur dans le résonateur et un élément non linéaire couplé à l'amplificateur pour limiter la puissance injectée dans le résonateur est caractérisé en ce que l'élément non linéaire est constitué par un matériau supraconducteur maintenu à basse température dans des conditions voisines de la transition entre l'état supraconducteur et l'état résistif.

L'invention sera mieux comprise et d'autres détails apparaîtront à l'aide de la description ci-dessous et des figures l'accompagnant :
– La figure 1 représente le schéma synoptique d'une première variante de réalisation de l'oscillateur selon l'invention ;
– La figure 2 représente le schéma synoptique d'une seconde variante de réalisation de l'oscillateur selon l'invention.

La résistivité d'un matériau supra-conducteur, parcouru par un courant continu, s'annule :
– si la température du matériau est inférieure à une température critique propre au matériau ;
– et si la densité de courant dans le matériau est inférieure à une densité critique ;
– et si le champ magnétique dans le matériau est inférieur à un champ critique.

Lorsqu'un matériau supra-conducteur est parcouru par un courant alternatif sa résistance ne s'annule pas complètement mais tend vers une valeur qui est très inférieure, de plusieurs ordres de grandeur, à la résistance du même matériau à la température ambiante. Cette variation de résistivité peut donc être induite en agissant soit sur la température, soit sur la densité de courant, soit sur le champ magnétique. Les deux derniers paramètres sont liés et ils permettent une variation très rapide de la résistance, sa durée se chiffrant en nanosecondes. La commutation de l'état quasi non résistif à l'état résistif sous l'action du champ magnétique ou de la densité de courant sera appelé commutation électrique, dans ce qui suit. La commutation sous l'action d'une variation de température est appelée commutation thermique, dans ce qui suit. Elle a une durée beaucoup plus longue, qui peut être de 1 microseconde ou de 1 seconde selon la façon dont est réalisée le dispositif non linéaire et les moyens de refroidissement qui fixent sa température. Les trois types de commutation ne sont pas totalement indépendants car le passage d'un courant agit à la fois par son effet Joule, sa densité de courant, et son champ magnétique.

Il est possible de faire commuter un matériau supra-conducteur selon l'un de ces 3 types de commutation, en choisissant convenablement la façon de réaliser l'élément non linéaire et de réaliser son refroidissement. La densité de courant engendrée par l'oscillation dans le matériau peut être amenée au voisinage de la densité critique en choisissant convenablement la section du matériau. Le champ magnétique créé par le courant de l'oscillation, dans le matériau, peut être amené au voisinage du champ critique en donnant une forme convenable au matériau. Dans les deux cas précédents la température du matériau est maintenue en-dessous de la température critique.

Dans le cas de la commutation thermique, la température de fonctionnement est fixée un peu en dessous de la température critique, et la commutation thermique est possible si les échanges thermiques avec le dispositif de refroidissement sont faibles. Pour cela, il convient d'utiliser un flux gazeux et non pas un liquide, comme réfrigérant.

Le choix du type de commutation dépend de la fréquence de l'oscillateur. Une commutation rapide relativement à la fréquence de l'oscillation, agit comme un écrêteur et génère donc des harmoniques, qui peuvent être indésirables. Par contre, avec une commutation lente, l'effet de limitation de l'amplitude de l'oscillation est réparti sur de nombreuses périodes de l'oscillation. Il provoque donc peu de distorsions de l'oscillation.

Il est donc possible d'utiliser la commutation thermique, en refroidissant le matériau supra-conducteur par un flux gazeux ayant une température un peu en dessous de la température critique, et en choisissant une composition et une forme de matériau telles qu'il ne fonctionne pas au voisinage de la densité critique et du champ critique, pour obtenir ainsi une commutation lente.

Pour obtenir une commutation électrique, qui est rapide, il convient de diminuer la section du matériau supra-conducteur, afin d'augmenter la densité de courant, et de refroidir ce matériau au moyen d'un liquide réfrigérant, car un liquide permet des échanges thermiques plus rapides qu'en utilisant un flux gazeux et permet donc de stabiliser parfaitement la température. Ou bien, il convient de mettre le matériau sous la forme d'une bobine pour concentrer dans le matériau le champ magnétique engendré par le courant traversant le matériau.

Les deux exemples de réalisation décrits ci-après mettent en oeuvre la commutation électrique, mais ils pourraient être facilement adaptés, selon les principes mentionnés ci-dessus, pour utiliser la commutation thermique, notamment dans le but de réaliser un oscillateur à basse fréquence.

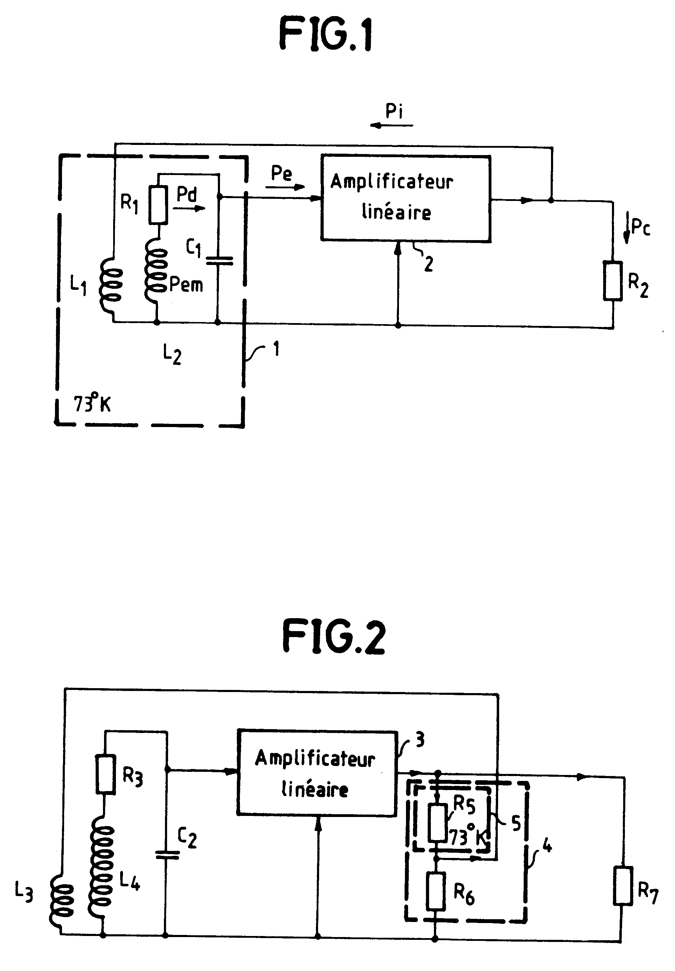

Sur la figure 1, la première variante de réalisation est un oscillateur dans lequel l'élément non linéaire est constitué par le résonateur lui-même. En effet, cet oscillateur comporte : un résonateur constitué d'une bobine $L_2$ et d'un condensateur $C_1$ ; un amplificateur linéaire 2, fonctionnant toujours dans sa zone de fonctionnement linéaire ; et une bobine $L_1$ couplée à la bobine $L_2$ pour entretenir les oscillations. Les bobines $L_1$ et $L_2$, et le condensateur $C_1$, sont constitués d'un matériau qui est supra-conducteur jusqu'à la température de 90°K. Ils sont maintenus à la température de 73°K par une enceinte 1 remplie d'azote liquide. Une entrée de l'amplificateur 2 est reliée à une première extrémité de la bobine $L_2$ et à une première extrémité du condensateur $C_1$. Une seconde extrémité de la bobine $L_2$ et une seconde extrémité du condensateur $C_1$ sont reliées à un potentiel de référence. Une première extrémité de la bobine $L_1$ est reliée à une sortie de l'amplificateur 2 et une seconde extrémité est reliée au potentiel de référence. La sortie de l'amplificateur 2 est reliée aussi à une charge $R_2$. Une autre entrée de l'amplificateur linéaire 2 est reliée au potentiel de référence.

Les pertes dues à l'effet Joule dans le résonateur sont représentées schématiquement par une résistance $R_1$ placée en série avec la bobine $L_2$. Les bobines $L_1$, $L_2$ et le condensateur $C_1$ étant maintenus à la température de l'azote liquide, ils sont loin de leur température critique qui est aux environs de 90°K. Des matériaux supra-conducteurs aux environs de 90°K sont décrits par exemple dans : la Recherche n° 190, juillet-Août 1987, pages 954-959, volume 18.

Physical Review B, vol 36 n° 4, 1er août 1987 page 2301, décrit la réponse en fréquence de tels matériaux supra-conducteurs.

La bobine $L_2$ a un nombre de spires tel que le champ magnétique créé dans le matériau supra-conducteur constituant ces spires est proche du champ critique lorsque l'amplitude des oscillations atteint la valeur souhaitée. La valeur souhaitée est telle que l'amplificateur 2 reste dans sa zone de fonctionnement linéaire. Le résonateur ainsi constitué joue le rôle d'un élément non linéaire limitant l'amplitude des oscillations, parce que lorsque le champ magnétique créé par la bobine $L_2$ est supérieur au champ critique, le matériau supra-conducteur constituant la bobine $L_2$ devient résistif et dissipe une partie de l'énergie accumulée dans le résonateur. La puissance $P_d$ dissipée dans le résonateur est alors une fonction croissante de l'amplitude de l'oscillation. Au contraire, lorsque l'amplitude de l'oscillation n'a pas encore atteint une valeur suffisante, le champ magnétique créé par la bobine $L_2$ ne dépasse le champ critique, il n'y a pratiquement aucune perte dans le résonateur et par conséquent l'énergie fournie par la sortie de l'amplificateur 2 s'accumule dans le résonateur. Dans ce cas, la puissance $P_i$ injectée dans le résonateur est supérieure à la somme de la puissance $P_d$ dissipée dans le résonateur et de la puissance $P_e$ qui est appliquée à l'entrée de l'amplificateur 2.

L'amplitude de l'oscillation se stabilise lorsque la puissance injectée $P_i$ est exactement égale à la somme de la puissante dissipée $P_d$ et de la puissance $P_e$ appliquée à l'entrée de l'amplificateur. L'amplicateur travaillant toujours en régime linéaire, son bruit à basse fréquence n'est pas converti en bruit à haute fréquence. Il n'y a que le bruit à haute fréquence de l'amplificateur qui contribue au bruit de l'oscillation. En ce qui concerne le résonateur, son bruit à basse fréquence est converti en bruit à haute fréquence, notamment en bruit de phase. A cause de la basse température du résonateur, son bruit est très faible, notamment dans les basses fréquences, donc le bruit de phase de l'oscillateur est très réduit. Cette réduction du bruit, par rapport aux dispositifs connus, est indépendante de la fréquence de fonctionnement de l'oscillateur. Ce dispositif permet donc de réaliser des oscillateurs à faible bruit et ayant une très haute fréquence.

Il est possible aussi de provoquer la transition de l'état supraconducteur à l'état résistif, du matériau constituant la bobine $L_2$, en réduisant la section du matériau de telle façon que la densité de courant soit proche de la densité critique, et atteigne cette valeur lorsque l'oscillation a l'amplitude souhaitée.

La figure 2 représente le schéma synoptique d'un second exemple de réalisation de l'oscillateur selon l'invention. Dans cette seconde variante, l'élément non linéaire de l'oscillateur est un dispositif 4 de contrôle automatique du gain de boucle de l'oscillateur, et comporte un élément non linéaire constitué d'un matériau supra-conducteur. En effet, l'oscillateur comporte : un résonateur constitué d'une bobine $L_4$ et d'un condensateur $C_2$ ; une bobine $L_3$ pour entretenir les oscillations ; un amplificateur 3, fonctionnant dans sa zone de fonctionnement linéaire ; le dispositif 4 de contrôle automatique du gain ; et une charge $R_7$.

Une première extrémité de la bobine $L_4$ et une première extrémité du condensateur $C_2$ sont reliées à une entrée de l'amplificateur 3. Une seconde extrémité de la bobine $L_4$ et une seconde extrémité du condensateur $C_2$ sont reliées à un potentiel de référence. Les pertes dans le résonateur sont représentées sur le schéma par une résistance $R_3$ intercalée en série avec la bobine $L_4$. La bobine d'entretien $L_3$ a une première extrémité reliée à une sortie du dispositif 4 et une seconde extrémité reliée au potentiel de référence. Une autre entrée de l'amplificateur 3 est reliée au potentiel de référence. La sortie de l'amplificateur 3 est reliée à une entrée du dispositif 4 et à une extrémité de la charge $R_7$. Une seconde extrémité de la charge $R_7$ et une entrée du dispositif 4 sont reliées aussi au potentiel de référence.

Le dispositif 4 est un atténuateur constitué de deux résistances $R_5$ et $R_6$, $R_6$ étant une résistance classique placée à la température ambiante alors $R_6$ est une résistance constituée d'un matériau qui est supra-conducteur jusqu'à la température de 90°K environ. Ce matériau est maintenu à une température inférieure à cette température critique, car la résistance $R_6$ est placée dans une enceinte thermostatique 5 à la température de l'azote liquide, 73°K. Une première extrémité de la résistance $R_5$ et une première extrémité de la résistance $R_6$ sont reliées ensembles et constituent la sortie du dispositif 4. Une seconde extrémité de la résistance $R_5$ et une seconde extrémité de la résistance $R_6$ constituent respectivement la première et la seconde entrée du dispositif 4.

La composition et la forme du matériau constituant la résistance $R_5$ sont choisies telles que le champ magnétique créé dans ce matériau par le courant qui le traverse, soit proche du champ critique lorsque l'oscillation atteint l'amplitude souhaitée. Lorsque l'amplitude des oscillations augmente, l'intensité du courant traversant les résistances $R_5$ et $R_6$ augmente. Le champ magnétique créé par ce courant dans le matériau constituant la résistance $R_5$, augmente. Lorsque ce champ magnétique atteint le champ critique, le matériau devient résistif, par une transition progressive. Le pont constitué par les résistances $R_6$ et $R_6$ n'atténue pratiquement pas la tension fournie par le dispositif 4 à la bobine $L_3$ tant que le champ critique n'est pas atteint. Il atténue la tension fournie par le dispositif 4 à la bobine $L_3$, quand l'amplitude des oscillations est telle que le champ magnétique dans le matériau de la résistance $R_6$ dépasse le champ critique. L'amplitude de l'oscillation se stabilise alors à une valeur telle que la puissance fournie au résonateur par le dispositif 4 est égale à la somme de la puissance dissipée dans la résistance $R_3$ du résonateur, et de la puissance appliquée à l'entrée de l'amplificateur 3.

Il est possible aussi de faire commuter le matériau sous l'action d'une augmentation de la densité de courant, au lieu d'une augmentation du champ magnétique. Pour cela, il faut donner au matériau une section telle que la densité de courant soit voisine de la densité critique, lorsque l'oscillation atteint l'amplitude souhaitée.

Dans cette seconde variante, l'amplificateur et le résonateur travaillant en régime linéaire, seul le bruit à basse fréquence du dispositif 4 de contrôle automatique de gain est converti en bruit à haute fréquence, notamment en bruit de phase. Le dispositif 4 ne comporte qu'un seul élément non linéaire, la résistance $R_5$. Outre le bruit à haute fréquence de l'amplificateur, le bruit de l'oscillateur est donc déterminé en partie par le bruit à basse fréquence de cette résistance $R_5$. Cette dernière ayant une température très basse, elle produit extrémement peu de bruit, notamment de bruit à basse fréquence susceptible d'être converti en bruit à haute fréquence à la sortie de l'oscillateur. Il y a donc une réduction du bruit de l'oscillateur.

L'invention ne se limite pas aux deux exemples de réalisation décrits ci-dessus. Le résonateur peut être constitué d'éléments à constantes non localisées, telles que des lignes ou des cavités. Il est à la portée de l'homme de l'art de réaliser aussi de nombreuses variantes du dispositif de contrôle automatique de gain 4, comportant une résistance non linéaire constituée d'un matériau supra-conducteur.

Il est possible aussi de rendre variable l'amplitude de l'oscillation en décalant la valeur du champ critique ou de la densité critique, notamment en faisant circuler un courant continu dans le matériau supra-conducteur constituant soit le résonateur, soit la résistance $R_5$, respectivement dans la première et la seconde variante ; ou bien en appliquant un champ magnétique crée par des moyens extérieurs au matériau.

L'invention est applicable à de nombreux types d'oscillateurs, notamment aux oscillateurs commandés par une tension, comportant une bobine, un condensateur fixe, et une diode à capacité variable. En effet, l'oscillateur selon l'invention ayant peu de bruit, il n'est pas nécessaire de filtrer énergiquement le bruit, par conséquent, il peut ne comporter aucun résonateur ayant un très haut coefficient de qualité.

**Revendications**

1. Oscillateur à faible bruit comportant un résonateur ($L_2$, $C_1$) connectés en boucle fermée à un amplificateur linéaire (2) au moyen d'un élément inductif ($L_1$) pour injecter une fraction de la puissance de sortie de l'amplificateur dans le résonateur ($L_2$, $C_1$) et un élément non linéaire couplé à l'amplificateur (2) pour limiter la puissance injectée dans le résonateur caractérisé en ce que l'élément non linéaire ($L_2$ $C_1$ ; $R_5$) est constitué par un matériau supraconducteur maintenu à basse température dans des conditions voisines de la transition entre l'état supraconducteur et l'état résistif.

2. Oscillateur selon la revendication 1, caractérisé en ce que le matériau supra-conducteur est placé dans des conditions telles qu'il passe à l'état résistif sous l'action d'un échauffement, lorsque l'amplitude de l'oscillation dépasse une valeur fixée, cet échauffement étant engendré, dans le matériau, par l'oscillation de l'oscillateur.

3. Oscillateur selon la revendication 1, caractérisé en ce que le matériau supra-conducteur est placé dans des conditions telles qu'il passe à l'état résistif sous l'action dune augmentation de la densité de courant dans le matériau, lorsque l'amplitude de l'oscillation dépasse une valeur fixée, ce courant étant engendré par l'oscillation de l'oscillateur.

4. Oscillateur selon la revendication 1, caractérisé en ce que le matériau supra-conducteur est placé dans des conditions telles qu'il passe à l'état résistif sous l'action dune augmentation du champ magnétique dans le matériau, lorsque l'amplitude de l'oscillation dépasse une valeur fixée, ce champ étant engendré par l'oscillation de l'oscillateur.

5. Oscillateur selon l'une des revendications 1 à 4, caractérisé en ce que l'élément non linéaire est constitué par le résonateur ($L_2$, $C_1$) lui-même celui-ci étant constitué d'un matériau supra-conducteur.

6. Oscillateur selon l'une des revendications 1 à 4, caractérisé en ce que l'élément non linéaire est un dispositif (4) de contrôle automatique du gain de l'amplificateur (3), et comporte une résistance non linéaire ($R_5$) . constituée d'un matériau supra-conducteur.

**Patentansprüche**

1. Rauscharmer Oszillator mit einem Resonator ($L_2$, $C_1$), der in einer geschlossenen Schleife mit einem linearen Verstärker (2) mit Hilfe eines induktiven Elements ($L_1$) zum Eingeben eines Teils der Ausgangsleistung des Verstärkers in den Resonator ($L_2$, $C_1$) verbunden ist, und einem mit dem Verstärker (2) gekoppelten nichtlinearen Element zum Begrenzen der in den Resonator eingegebenen Leistung, dadurch gekennzeichnet, daß das nichtlineare Element ($L_2$ $C_1$; $R_5$) von einem Supraleitermaterial gebildet ist, das auf einer Niedrigtemperatur unter Bedingungen nahe dem Übergang zwischen dem supraleitenden und dem widerstandsbehafteten Zustand gehalten ist.

2. Oszillator nach Anspruch 1, dadurch gekennzeichnet, daß das Supraleitermaterial unter Bedingungen gesetzt ist, daß es unter der Einwirkung einer Erwärmung in den widerstandsbehafteten Zustand übergeht, wenn die Schwingungsamplitude einen festen Wert überschreitet, wobei die Erwärmung in dem Material durch die Schwingung des Oszillators erzeugt wird.

3. Oszillator nach Anspruch 1, dadurch gekennzeichnet, daß das Supraleitermaterial unter Bedingungen gesetzt ist, daß es in den widerstandsbehafteten Zustand unter der Einwirkung einer Vergrößerung der Stromdichte in dem Material übergeht, wenn die Schwingungsamplitude einen festen Wert überschreitet, wobei der Strom durch die Schwingung des Oszillators erzeugt wird.

4. Oszillator nach Anspruch 1, dadurch gekennzeichnet, daß das Supraleitermaterial unter Bedingungen gesetzt ist, daß es in den widerstandsbehafteten Zustand unter der Einwirkung einer Erhöhung des Magnetfeldes in dem Material übergeht, wenn die Amplitude der Schwingung einen festen Wert übersteigt, wobei das Feld von der Schwingung des Oszillators erzeugt wird.

5. Oszillator nach einem der Ansprüche 1 bis 4, dadurch gekennzeichnet, daß das nichtlineare Element von dem Resonator ($L_2$, $C_1$) gebildet ist, das seinerseits von einem Supraleitermaterial gebildet ist.

6. Oszillator nach einem der Ansprüche 1 bis 4, dadurch gekennzeichnet, daß das nichtlineare Element eine Vorrichtung (4) zur Verstärkungsregelung des Verstärkers (3) ist und einen nicht linearen Widerstand ($R_5$) enthält, der aus einem Supraleitermaterial gebildet ist.

**Claims**

1. Low-noise oscillator comprising a resonator ($L_2$, $C_1$) connected in a closed loop to a linear amplifier (2) by means of an inductive element ($L_1$) for injecting a fraction of the output power of the amplifier into the resonator ($L_2$, $C_1$) and a non-linear element coupled to the amplifier (2) for limiting the power injected into the resonator, characterised in that the non-linear element ($L_2$, $C_1$; $R_5$) is made of a superconductive material kept at a low temperature under conditions close to the transition between the superconductive state and the resistive state.

2. Oscillator according to claim 1, characterised in that the superconductive material is placed under conditions such that it changes to the resistive state under the action of heating, when the amplitude of oscillation exceeds a fixed value, this heating being caused, in the material, by oscillation of the oscillator.

3. Oscillator according to claim 1, characterised in that the superconductive material is placed under conditions such that it changes to the resistive state under the action of an increase in current density in the material, when the amplitude of oscillation exceeds a fixed value, this current being caused by oscillation of the oscillator.

4. Oscillator according to claim 1, characterised in that the superconductive material is placed under conditions such that it changes to the resistive state under the action of an increase in the magnetic field in the material, when the amplitude of oscillation exceeds a fixed value, this field being caused by oscillation of the oscillator.

5. Oscillator according to any of claims 1 to 4, characterised in that the non-linear element consists of the resonator ($L_2$, $C_1$) itself, the latter being made of a superconductive material.

6. Oscillator according to any of claims 1 to 4, characterised in that the non-linear element is a device (4) for automatic gain control of the amplifier (3), and comprises a non-linear resistance ($R_5$) made of a superconductive material.

# FIG.1

# FIG.2